(19) Europäisches Patentamt

European Patent Office

Office européen des brevets

(11) EP 0 801 399 A2

## (12) EUROPEAN PATENT APPLICATION

(43) Date of publication:
15.10.1997 Bulletin 1997/42

(51) Int Cl.6: **G11C 27/02**

(21) Application number: 97302335.1

(22) Date of filing: 04.04.1997

(84) Designated Contracting States:
DE FR GB

(30) Priority: 08.04.1996 JP 84860/96

(71) Applicant: SONY CORPORATION
Tokyo (JP)

(72) Inventors:
• Katakura, Masayuki
Shinagawa-ku, Tokyo (JP)

• Takeda, Masashi
Shinagawa-ku, Tokyo (JP)

(74) Representative: Nicholls, Michael John
J.A. KEMP & CO.
14, South Square
Gray's Inn
London WC1R 5LX (GB)

### (54) Analog delay circuit

(57) In an analog delay circuit having an analog-value memory circuit comprising memory cells arranged to form a matrix with each memory cell comprising a memory-cell capacitor and a select-switch device, read switches, write switches and reset switches are provided for the rows to form a read/write circuit. When a memory cell is selected, the capacitance of a parasitic capacitor connected to write and read nodes is reduced to the capacitance of a parasitic capacitor of one row selected by the select-switch device and, at the same time, electric charge accumulated in the parasitic capacitor of the selected row is reset by one of the reset switches provided for the selected row immediately prior to a read operation to read electric charge of the selected memory cell on the row, eliminating noise caused by the electric charge accumulated in the parasitic capacitor of the selected row.

FIG. 6

EP 0 801 399 A2

## Description

The present invention relates in general to an analog delay circuit and in particular to an analog delay circuit for delaying an analog signal by carrying out read/write operations repeatedly in a predetermined number of read/write cycles on capacitors of memory cells arranged to form a two-dimensional matrix.

An analog delay circuit for delaying an analog signal is typically used in an audio echo circuit and a colour TV receiver. In a colour TV receiver adopting the PAL or SECAM system, an analog delay circuit is indispensable for a demodulation circuit of a colour-difference signal completing multiple modulation. In a colour TV receiver adopting the NTSC system, on the other hand, an analog delay circuit is used for enhancement of the picture quality by separation of chrominance and luminance signals from each other. In the case of the PAL system, for example, one of the two modulated chrominance signals is transmitted after undergoing polarity inversion for each scanning row so that a 1H delay circuit is required in a chrominance-signal demodulating circuit in order to obtain correlation. It should be noted that, by 1H, a horizontal sweeping period is meant. A glass delay line is used as an analog delay circuit. However, an analog delay circuit can also be implemented by charged-coupled devices (CCDs).

An analog delay circuit implemented by a glass delay line or CCDs as cited above is configured as a device separated from a chrominance-signal demodulating circuit. On the other hand, it is desirable to have an analog delay circuit and a chrominance-signal demodulating circuit integrated into a single device by creating the analog delay circuit on the chip of the chrominance-signal demodulating circuit. Since input/output pins of the analog delay circuit are eliminated, not only is an analog delay IC unnecessary, but the number of pins required by a chrominance-signal demodulating IC itself is also reduced, allowing both the circuits to be accommodated in a small-size package which in turn allows new functions to be added with ease. That is why the integration of the chrominance-signal demodulating circuit and the analog delay circuit into a single device is desirable.

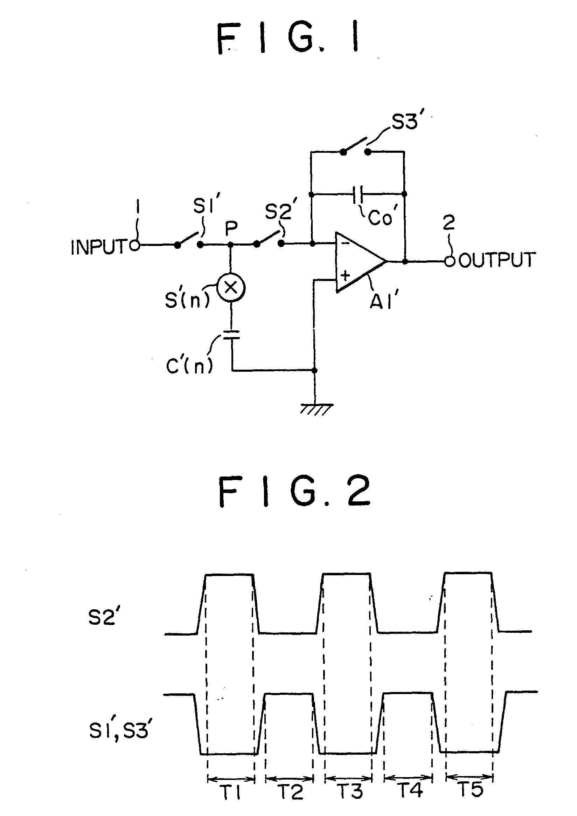

As an analog delay circuit integratable with a chrominance-signal demodulating circuit into a single device as described above, a typical circuit configuration like the one shown in Fig. 1 of the accompanying drawings is known. As shown in the figure, a write switch S1' and a read switch S2' are connected in series between a circuit input pin 1 and the inverted input (-) terminal of an operational amplifier A1'. The uninverted input (+) terminal of the operational amplifier A1' is connected to the ground and the output terminal thereof is connected to a circuit output pin 2. An integration capacitor Co' and a reset switch S3' are connected to each other in parallel between the inverted-input terminal and the output terminal of the operational amplifier A1'. n series circuits are connected in parallel between the connection point P between the write switch S1' and the read switch S2' and the ground. Each of the series circuit comprises a select switch Sn' and a memory-cell capacitor C(n)'.

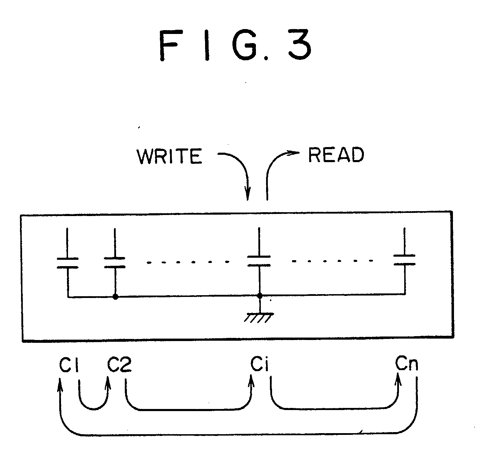

Fig. 2 is a diagram showing timing charts of the operations of the write, read and reset switches S1' to S3'. An analog-delay principle based on these timing charts is explained by referring to a conceptual diagram of Fig. 3. First of all, in a period T1, the write and reset switches S1' and S3' are open while the read switch S2' is closed. In this period T1, signal electric charge of the ith memory-cell capacitor Ci' is therefore read out into the integration capacitor Co'. In a period T2, on the other hand, the write switch S1' is closed while the read switch S2' is open, causing an input signal to be written into the ith memory-cell capacitor Ci' as signal electric charge. At the same time, the reset switch S3' is closed, causing the integration capacitor Co' to be reset in order to prepare the integration capacitor Co' for the next read operation.

Next, in a period T3, signal electric charge of the (i+1)th memory-cell capacitor C(i+1)' is read out into the integration capacitor Co' and, in a period T4, an input signal is written into the (i+1)th memory-cell capacitor C(i+1)' as signal electric charge and the integration capacitor Co' is reset. These read and write operations are sequentially carried out on the n memory cells C1' to C(n)'. That is to say, signal electric charge written previously into the ith memory-cell capacitor Ci' is read out and then the signal electric charge of an input current is written into the memory cell Ci'. The read and write operations are carried out on one memory-cell capacitor sequentially one after another starting with Ci' to be followed by C(i+1)', ... to C(n)', then to C1' before returning to Ci'. Thus, an operation to read out signal electric charge lags behind an operation to write the same signal electric charge by a time delay of n x T where notation n is the number of memory-cell capacitors Ci' and notation T denotes a read/write operation cycle. As a result, the analog input signal is delayed by a time n x T.

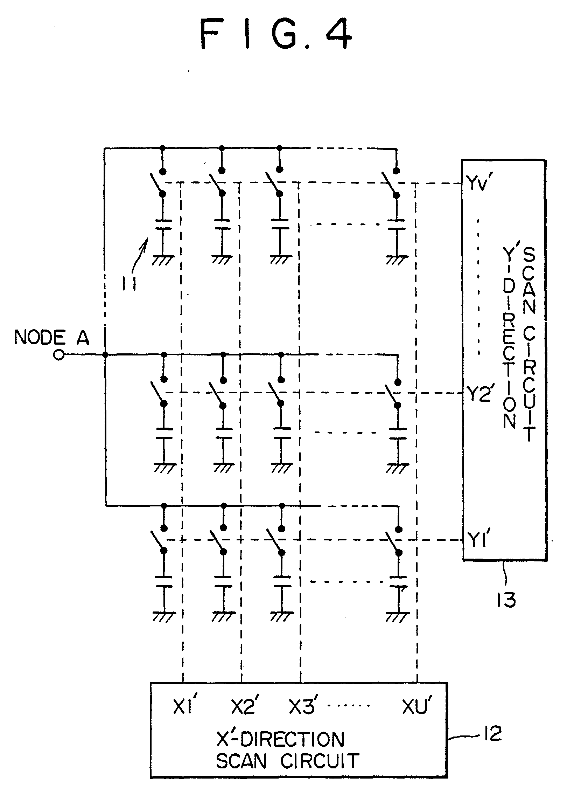

The n select switches Sn' are actuated sequentially one after another by using a scan circuit which typically employs a shift register. In this case, the shift register of the scan circuit is an n-bit register having as many bits as memory cells. As the number of memory cells (n) increases, the size of the scan circuit also increases accordingly, giving rise to a problem that a strict limitation has to be imposed on the number of memory cells (n) from the chip-occupation-area and chip-power-consumption points of view. As a measure to counter this problem, we can generally think of a configuration wherein memory cells 11 are arranged in X' and Y' directions to form a matrix, and an X'-direction scan circuit 12 and a Y'-direction scan circuit 13 are provided as shown in Fig. 4 to allow any arbitrary memory cell 11 in the matrix to be selected.

Even with such a matrix configuration, as the number of memory cells (n) further increases, none the less, a new problem arises. To put it in detail, a common node A involved in read and write operations as shown in Fig. 4 is connected to one terminal of each of the n select switches Sn' and pieces of semiconductor for the connection are spread over the entire area of the memory-cell regions. Typically, the select switch Sn' is implemented by a semiconductor switch device such as a MOSFET, a JFET (junction FET) or a bipolar transistor. Such a switch device has a parasitic capacitance between the ground and a control electrode (that is, the gate or the base) thereof. In addition, each piece of connection semiconductor itself also has a large parasitic capacitance with respect to the substrate as well. With the number of memory cells (n) exceeding 100, a case in which the parasitic capacitance is larger than the capacitance of the memory-cell capacitor C(n)' is not unusual.

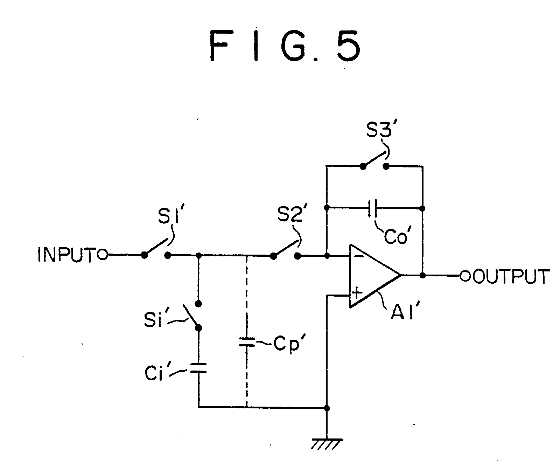

Here, a problem caused by a large parasitic capacitance at the common node A is explained. Fig. 5 is a diagram showing an analog delay circuit with a parasitic capacitance added thereto. A memory-cell capacitor Ci' and a select switch Si' in this analog delay circuit replace the n memory-cell capacitors C(n)' and the n select switches Sn' shown in Fig. 1 respectively. Notation Cp' is a parasitic capacitor having the added parasitic capacitance cited above. There are two big problems caused by the capacitance of the parasitic capacitor Cp'.

One of the problems is that signal electric charge is also accumulated in the parasitic capacitor Cp'. An operation to read out the signal electric charge from the parasitic capacitor Cp' does not lag behind an operation to write it by n clock pulses. Instead, the signal electric charge is read out from the parasitic capacitor Cp' right after it is written. That is to say, a feed-through phenomenon in which the signal gets out as it is without being delayed is observed.

The other problem is that, in an attempt to read signal electric charge of the memory-cell capacitor Ci' and transfer the charge to the integration capacitor Co' by way of the read switch S2', the parasitic capacitor Cp' connected to the input of the operational amplifier A1' in parallel to the memory-cell capacitor Ci' is encountered. With the capacitance of the parasitic capacitor Cp' greater than that of the integration capacitor Co', the feedback ratio of the operational amplifier A1' decreases, giving rise to a problem that the response speed is reduced and the amount of noise is increased.

The present invention addresses the problems described above. It is an object of the present invention to provide an analog delay circuit that has good characteristics in that the effect of signal electric charge accumulated in the parasitic capacitor is reduced, the response is excellent and the amount of noise is small.

In order to achieve the object described above, the present invention provides an analog delay circuit comprising:

an analog-value memory circuit comprising (u x v) memory cells (where notations u and v are natural numbers) arranged to form a matrix comprising u columns and v rows wherein each of said memory cells comprises a switch device with one terminal thereof connected to a row line and a memory-cell capacitor connected between the other terminal of said switch device and the ground;

a read/write circuit comprising sets of switches each comprising a read switch, a write switch and a reset switch for each of the said v rows wherein one terminal of said write switch is connected to an input node while the other terminal of said write switch is connected to one end of said row line of said row, one terminal of said read switch is connected an output node while the other terminal of said read switch is connected to said end of said row line of said row and one terminal of said reset switch is connected to said output node while the other terminal of said reset switch is connected to said end of said row line of said row;

a first scan circuit for sequentially outputting u column-select signals for driving said switch devices of said memory cells on a one-column-after-another basis;

a second scan circuit for sequentially outputting v row-select signals for driving said switch devices of said memory cells on a one-row-after-another basis; and

a control circuit for driving and controlling said read/ write circuit by using a read signal, a write signal and said row-select signals wherein said jth write switch (where $1 \leqslant j \leqslant v$ and $(v + 1)$ is treated as 1) and said $(j + 1)$th reset switch are driven with the same timing.

In the analog delay circuit described above, when the column-select signal of the ith column and the row-select signal of the jth row are both put in an active state, a memory cell on the ith column and the jth row of the analog-value memory circuit is selected and the switch device of the memory cell is put in a conductive (closed) state. At the same time, the read and write switches of the jth row are selected and put in a conductive state. In this state of selection, only the switch devices of the memory cells on the jth row are connected to the input and output nodes. In this state, an operation to read out or write electric charge is carried out on the memory-cell capacitor of the memory cell on the jth row which is also on the ith column.

As a result, only the parasitic capacitors of the switch devices on one row are connected to the input and output nodes. Thus, the total capacitance of the parasitic capacitors connected to the input and output nodes is small in comparison with the conventional circuit in which the parasitic capacitors of all the switch devices are connected. In addition, unnecessary residual electric charge left in the parasitic capacitors right after a write operation is reset by the reset switch immediately before a next read operation.

The invention will be further described by way of example, with reference to the accompanying drawings, in which:-

Fig. 1 is a diagram showing the basic circuit of an analog delay circuit;

Fig. 2 is a diagram showing timing charts of operations of switches S1' to S3' of the analog circuit shown in Fig. 1;

Fig. 3 is a conceptual diagram showing the principle of an analog delay;

Fig. 4 is a diagram showing the related art analog delay circuit;

Fig. 5 is a diagram showing the basic circuit of the analog delay circuit including a parasitic capacitor;

Fig. 6 is a circuit diagram showing the configuration of a first embodiment implementing an analog delay circuit provided by the present invention;

Fig. 7 is a diagram showing operational waveforms appearing at a variety of portions in the first embodiment;

Fig. 8 is a diagram showing the basic circuit of the analog delay circuit provided by the present invention;

Fig. 9 is a explanatory diagram showing timing charts used for describing the operation of the circuit shown in Fig. 8;

Fig. 10 is a circuit diagram showing the configuration of a second embodiment implementing an analog delay circuit provided by the present invention;

Fig. 11 is a diagram showing a typical circuit of a memory cell;

Fig. 12 is a circuit diagram showing the configuration of a third embodiment implementing an analog delay circuit provided by the present invention; and

Fig. 13 is a circuit diagram showing the configuration of a fourth embodiment implementing an analog delay circuit provided by the present invention.

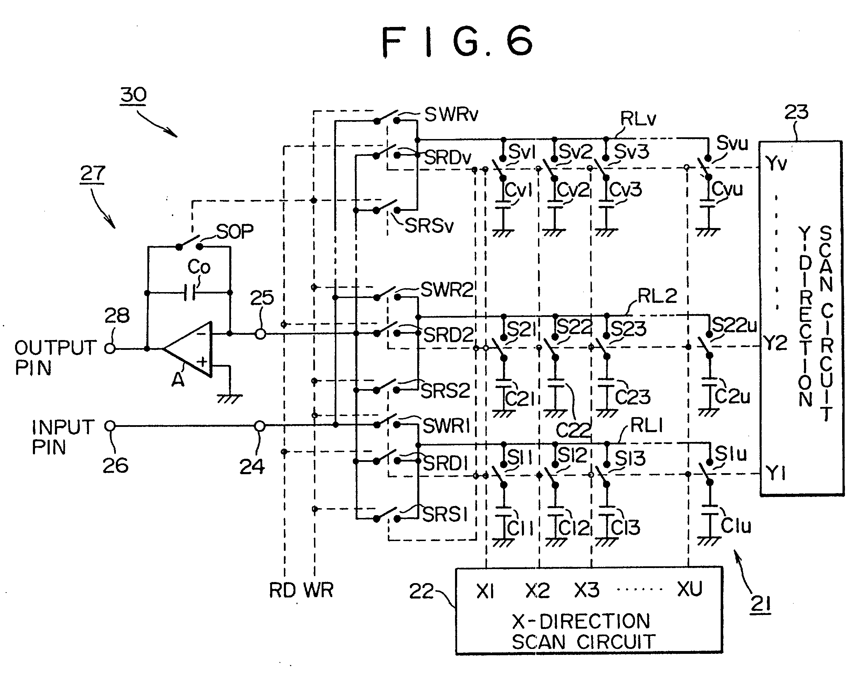

The present invention will become more apparent from the following detailed description of preferred embodiments with reference to accompanying diagrams showing the embodiments. Fig. 6 is a circuit diagram showing a first embodiment implementing an analog delay circuit provided by the present invention. It should be noted that Fig. 6 mainly shows the configuration of an analog-value memory circuit, the principle part of the present invention. The analog-value memory circuit is a portion of the analog delay circuit which corresponds to the circuit comprising the n select switches Sn' and the n memory-cell capacitors C(n)' shown in Fig. 1.

In the analog-value memory circuit 21 shown in Fig. 6, a memory cell comprises a memory-cell capacitor Cmn and a select switch Smn connected in series between a row line RLn and the ground. The analog-value memory circuit 21 comprises a plurality of such memory cells which are arranged to form a matrix comprising u columns and v rows. The (u x v) memory cells C11 to Cvu in the matrix have (u x v) select switches S11 to Svu respectively. One of the (u x v) select switches S11 to Svu is selected by one of X-direction column-select lines X1 to Xu and one of Y-direction row-select lines Y1 to Yv. An operation is then carried out to read out or write signal electric charge from or into a memory cell Cmn associated with a selected select switch Smn in such a matrix driving technique. Normally, the select switches S11 to Svu are each implemented by a semiconductor switch device such as a bipolar transistor, a J (junction-type) FET or a MOSFET.

In order to carry out operations to read and write signal electric charge by using this matrix-driving technique as described above, an X-direction scan circuit 22 and a Y-direction scan circuit 23 are provided. The X-direction scan circuit 22 outputs column-select signals X1 to Xu sequentially one signal after another. By the same token, the Y-direction scan circuit 23 outputs row-select signals Y1 to Yv sequentially one signal after another. The X-direction and Y-direction scan circuits 22 and 23 are each implemented by typically a shift register.

The analog delay circuit provided by the present invention has the analog-value memory circuit 21 comprising the (u x v) memory cells, that is, the memory-cell capacitors C11 to Cvu and the select switches S11 to Svu, which are arranged to form the two-dimensional matrix of u columns and v rows as described above. The embodiment implementing the analog-value memory circuit 11 has a configuration wherein write switches SWR1 to SWRv, read switches SRD1 to SRDv and reset switches SRS1 to SRSv are provided for each row to form a read/write circuit 30.

Speaking concretely, one terminal of each of the write switches SWR1 to SWRv is connected to a write node (an input node) 24 while the other terminals thereof are connected to ends on one side of row lines RL1 to RLv respectively. On the other hand, one terminal of each of the read switches SRD1 to SRDv is connected to read node (an output node) 25 while the other terminals thereof are connected to the ends of the row lines RL1 to RLv respectively which are connected to the write switches SWR1 to SWRv as described above. Much like the reset switches SRD1 to SRDv, one terminal of each of the read switches SRS1 to SRSv is connected to the read node 25 while the other terminals thereof are connected to the same ends of the row lines RL1 to RLv respectively.

The write switch SWRi on the ith row is selected by the row-select signal Yi and a write signal WR in a matrix driving operation. By the same token, the read switch SRDi on the ith row is selected by the row-select signal Yi and a read signal RD in a matrix driving operation. On the other hand, the reset switch SRSi on the ith row is selected by the row-select signal Y(i-1) and the write signal WR in a matrix driving operation.

The write node 24 is connected to an external input pin 26 of typically an IC and the read node 25 is connected to the inverted-input terminal of an operational amplifier A. The uninverted-input terminal of the operational amplifier A is, on the other hand, connected to the ground. An integration capacitor Co and a reset switch SOP are connected to each other in parallel between the inverted-input terminal and the output terminal of the operational amplifier A. The integration capacitor Co, the reset switch SOP and the operational amplifier A constitute an output circuit 27. The output terminal of the operational amplifier A is connected to an output pin 28.

By the way, there are two representative methods for scanning in the X and Y directions. In one of the methods, scanning in the Y direction is carried out at a scanning rate of 1 row per clock. After the scanning of all rows in the Y direction along a column has been completed, scanning in the X direction is shifted to the next column. The scanning according to this first method is similar to the raster scanning carried out in a television. In the other method, on the other hand, the scanning in the X direction is shifted to the next column and the scanning in the Y direction is shifted to the next row every one clock. With this second method, all memory cells are scanned in a slanting direction in accordance with a certain rule.

In the case of the slanting-direction scanning according to the second method, the column-select signal Xi and the row-select signal Yj each have a width of 1 clock for any memory cell. Therefore, since the driving condition is the same for all the memory cells, fixed-pattern noise is hardly generated. In the case of the raster scanning according to the first method, on the other hand, there may be a difference in gate-electrode waveform between the MOSFETs Qij on 1 or u columns or between any two columns. Such a difference in gate-electrode waveform or a subtle difference in conductive state thereof will appear through the parasitic capacitor of the MOSFET as a change in gain of an input/output characteristic of the input and output signals or a change in offset characteristic thereof which may cause fixed-pattern noise to be generated.

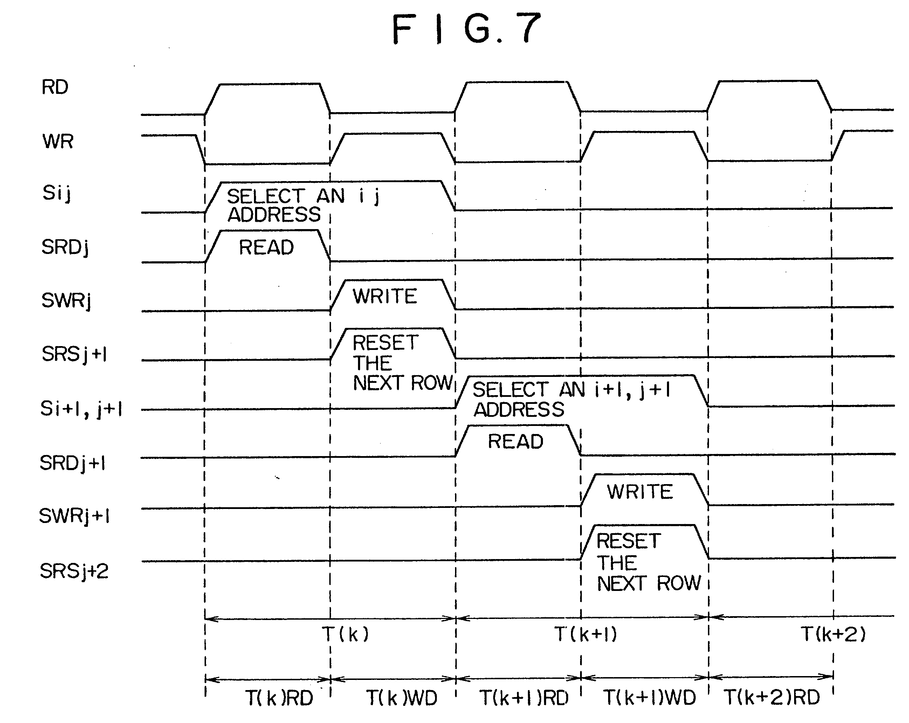

For this reason, an analog delay circuit provided by the first embodiment having the configuration described above adopts the second scanning method which is characterized in that fixed-pattern noise is hardly generated. Operations of the analog delay circuit adopting the second scanning method are explained by referring to waveforms shown in Fig. 7 as follows.

In the first place, both the read and write signals RD and WR used in the analog delay circuit are pulse signals having the same clock frequency but phases different from each other by 180 degrees. Let a kth period Tk be assigned to a memory cell on the ith column and the jth row of the matrix. The column-select signal xi and the row-select signal Yj output in a matrix driving operation turns on the select switch Sij, connecting the memory-cell capacitor Cij to the jth row line RLj.

The first half TkRD of the period Tk is a read sub-period during which the read signal RD is raised to a high level, which is also referred to hereafter as a "H" level, to turn on or close the read switch SRDj. With the read switch SRDj turned on, the jth row line RLj is connected to the inverted-input terminal of the operational amplifier A employed in the output circuit 27, transferring signal electric charge of the memory-cell capacitor Cij to the integration capacitor Co of the output circuit 27.

During a write sub-period T(k)WR, the second half of the period Tk following the read sub-period TkRD, the read signal RD is reset to a low level, which is also referred to hereafter as a "LOW" level, while the write signal WR is set to the "H" level. As a result, the read switch SRDj is turned off or opened while the write switch SWRj is turned on. In this state, the jth row line RLj is connected to the input pin 26 through the write node 24, causing signal electric charge of an input signal to be accumulated in the memory-cell capacitor Cij. At that time, the input line leaves the electric charge not only in the memory-cell capacitor Cij but also in a parasitic capacitor of the jth row line RLj.

In the write sub-period T(k)WR, the (j + 1)th reset switch SRS(j+1) is turned on to connect the (j + 1)th row line RL(j+1) to the inverted-input terminal of the operational amplifier A. Since the inverted-input terminal is always at the ground electric potential, the electric charge of the parasitic capacitor of the (j+1)th row is reset to zero. During this write sub-period T(k)WR, since the reset switch SOP of the integration capacitor Co is turned on by the write signal WR, the electric charge of the parasitic capacitor does not have an effect on the output.

As the operation to reset the parasitic capacitor of the (j+1)th row line RL(j+1) is completed, the analog delay circuit enters the next period T(k+1) in which the select switch S(i+1)(j+1) is turned on, connecting the memory-cell capacitor C(i+1)(j+1) to the (j+1)th row line RL (j+1) which has just completed the reset operation. Much like the period Tk, in the read sub-period T(k+1) RD, the signal electric charge of the memory-cell capacitor C(i+1) (j+1) is read out whereas, in the following write sub-period T(k+1)WR, signal electric charge is written into the memory-cell capacitor C(i+1)(j+1) and the parasitic capacitor of the (j+2)th row line RL(j+2) is reset.

As described above, the analog delay circuit has an analog-value memory circuit 21 comprising memory cells arranged to form a two-dimensional matrix having u rows and v columns. The memory cells each comprise a memory-cell capacitor Cmn and a select switch Smn. Write switches SWR1 to SWRv, read switches SRD1 to SRDv and reset switches SRS1 to SRSv are provided for each row of the matrix. Since only the select switches Smn associated with a row are selected at one time by using the matrix driving technique, only a parasitic capacitor of the select switches Smn of the selected row is connected to the write and read nodes 24 and 25. Thus, the capacitance of the parasitic capacitor connected to the write and read nodes 24 and 25 is very small in comparison with the conventional technology in which the parasitic capacitor of all the select switches Sn is involved.

As a result, the analog delay circuit provided by the present invention is capable of solving the problems encountered in the related art that the feedback ratio of the operational amplifier A1' shown in Fig. 1 substantially decreases in an operation to read out signal electric charge of the memory-cell capacitor Cmn, making it difficult to read out the signal electric charge at a high speed. In addition, the amount of unnecessary electric charge which is accumulated in a parasitic capacitor and not delayed is also reduced considerably, allowing the magnitude of interference to the output caused by the unnecessary electric charge to be decreased as well. On the top of that, since unnecessary residual electric charge left in the parasitic capacitors right after a write operation is reset by the reset switches SRS1 to SRSv immediately before a next read operation, the unnecessary residual electric charge does not have any effect on the output signal.

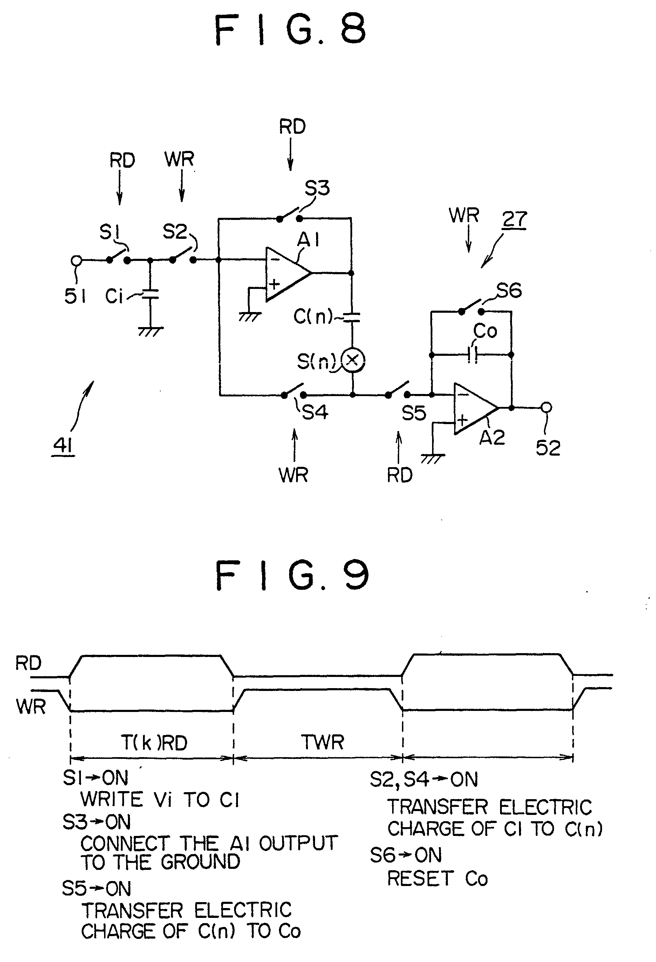

The circuit described above is based on the concept of the analog delay circuit shown in Fig. 1. On the other hand, Fig. 8 is a diagram showing an analog delay circuit embracing a different concept. The analog delay circuit shown in Fig. 1 has a shortcoming that variations in memory-cell capacitance cause fixed-pattern noise. To put it in detail, when a voltage Vi is applied to an nth memory-cell capacitor C(n)', electric charge Qn' accumulated therein is given by the following equation:

$$Qn' = Vi \times C(n)'$$

where notation C(n)' used in the above equation denotes the capacitance of the memory-cell capacitor C(n)'. The electric charge Qn' is transferred to the integration capacitor Co' to give an output voltage Vo across the capacitor Co' which can be expressed by the following equation:

$$Vo = Vi \times C(n)' / Co'$$

where notation Co' used in the above equation denotes the capacitance of the integration capacitor Co'. It is obvious from the above equation that the output voltage Vo is dependent on the memory-cell capacitance C(n)' and, thus, affected by variations in memory-cell capacitance C(n)'.

Since relative variations in memory-cell capacitance C(n)' are normally of the order of about 1%, the fixed-pattern noise is not a big problem in the case of a video signal. None the less, the noise is not desirable. However, the concept of the analog delay circuit shown in Fig. 8 solves this problem. The configuration of the analog delay circuit shown in Fig. 8 is explained as follows.

As shown in the figure, one terminal of a switch S1 is connected to an input pin 51 while the other terminal thereof is connected to one terminal of a switch S2 and one terminal of an input capacitor Ci. The other terminal of the input capacitor Ci is connected to the ground and the other terminal of the switch S2 is connected to the inverted-input terminal of an operational amplifier A1. The uninverted-input terminal of the operational amplifier A1 is also connected to the ground. A switch S3 is connected between the inverted-input terminal and the output terminal of the operational amplifier A1. The switches S1, S2 and S3, the input capacitor Ci and the operational amplifier A1 constitute an input circuit 41. The switches S1 and S3 are turned on and off in synchronization with a read signal RD whereas the switch S2 is turned on and off in synchronization with a write signal WR.

One terminal of each of n memory-cell capacitors C(n) is connected to the output terminal of the operational amplifier A1. The other terminal of each of the memory-cell capacitors C(n) is connected to one terminal of one of n select switches Sn. The other terminal of each of the select switches Sn is connected to one terminal of a switch S4 as well as to one terminal of a switch S5. The other terminal of the switch S4 is connected to the inverted-input terminal of the operational amplifier A1. As for the switch S5, the other terminal thereof is connected to the inverted-input terminal of an operational amplifier A2.

The uninverted-input terminal of the operational amplifier A2 is also connected to the ground. An integration capacitor Co and a switch S6 are connected to each other in parallel between the inverted-input terminal and the output terminal of the operational amplifier A2. The output terminal of the operational amplifier A2 is connected to an output pin 52. The switches S4, S5 and S6, the integration capacitor Co and the amplifier A2 constitute an output circuit 27. The switches S4 and S6 are turned on and off in synchronization with the write signal WR whereas the switch S5 is turned on and off in synchronization with the read signal RD.

In the analog delay circuit with the configuration described above, an input signal is once accumulated in the input capacitor Ci before being transferred to the memory-cell capacitor C(n) as electric charge instead of a voltage. The electric charge is read out and accumulated into the integration voltage Co. In this way, the conversion of an input voltage into electric charge and the conversion of the electric charge into an output voltage are carried out by the input and integration capacitor Ci and Co respectively. Since the memory-cell capacitors C(n) are used merely for preserving the electric charge, the performance of the analog delay circuit in essence does not have something to do with the capacitance of each of the memory-cell capacitors C(n).

Fig. 9 is a diagram showing timing charts used for explaining the operation of the analog delay circuit shown in Fig. 3. In a period TkRD during which the read signal RD is at the "H" level, the switches S1, S3 and S5 are in an on state. As a result, the input voltage is written into the input capacitor Ci and the upper terminal of the memory-cell capacitor C(n) is set at the electric potential of the ground. In the mean time, electric charge is transferred from a memory-cell capacitor Ci indicated by an address specified in this read operation to the integration capacitor Co.

In a period T(k)WR during which the write signal WR is at the "H" level, on the other hand, the switches S2, S4 and S6 are in an on state. Since the switch S3 is off but the switch S4 is on, the operational amplifier A1 works with the memory-cell capacitor C(n) serving as a feedback circuit as well as an integration circuit, transferring the electric charge accumulated in the input capacitor Ci to the memory-cell capacitor C(n). With the switch S6 put in an on state, the operational amplifier A2 resets the integration amplifier Co. It is obvious from the operations described above that effects of relative variations in capacitances among the memory-cell capacitors C(n) can be eliminated.

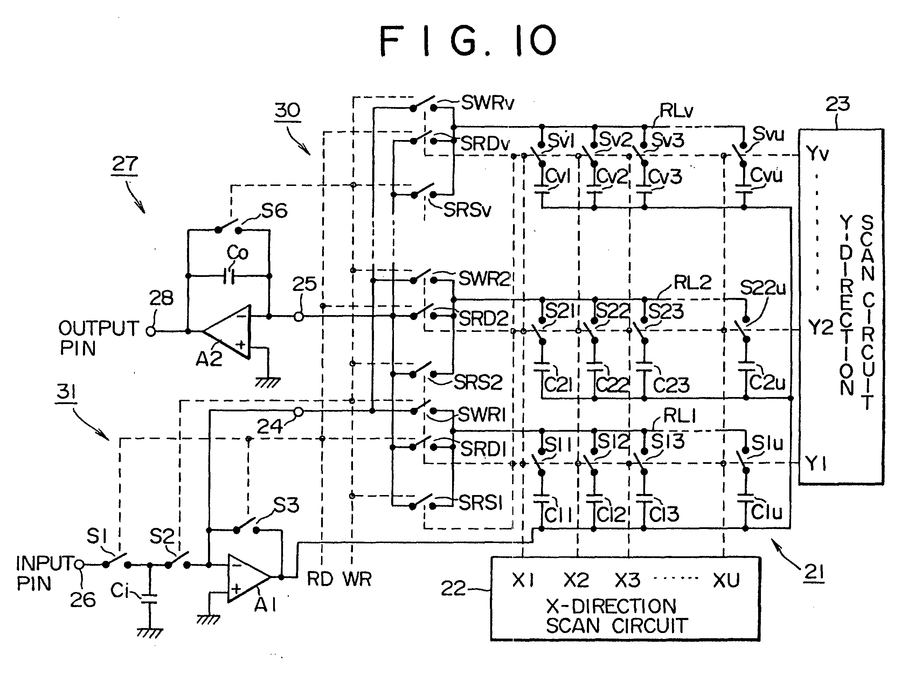

Fig. 10 is a diagram showing the configuration of a second embodiment of the present invention for implementing an analog delay circuit that adopts the concept described above. In the figure, any component identical with that shown in Fig. 6 is denoted by the same reference numeral as that of Fig. 6. The second embodiment has the same configuration as the first embodiment shown in Fig. 6 as far as the configuration of the analog-value delay circuit 21 and the write switches SWR1 to SWRv, the read switches SRD1 to SRDv and the reset switches SRS1 to SRSv provided for each row are concerned. In addition, the input and output pins 26 and 28 shown in Fig. 10 correspond respectively to the input and output terminals 51 and 52 shown in Fig. 8.

Much like the circuit shown in Fig. 8, one terminal of a switch S1 is connected to the input pin 26 while the other terminal thereof is connected to one terminal of a switch S2 and one terminal of an input capacitor Ci. The other terminal of the input capacitor Ci is connected to the ground and the other terminal of the switch S2 is connected to the inverted-input terminal of an operational amplifier A1. The uninverted-input terminal of the operational amplifier A1 is also connected to the ground. A switch S3 is connected between the inverted-input terminal and the output terminal of the operational amplifier A1. The output terminal of the operational amplifier A1 is connected to terminals on one side of n memory-cell capacitors C(n). The inverted-input terminal of the operational amplifier A1 is also connected to a write node 14. The switches S1, S2 and S3, the input capacitor Ci and the operational amplifier A1 constitute an input circuit 31.

A read node 25 is connected to the inverted-input terminal of an operational amplifier A2. The uninverted-input terminal of the operational amplifier A2 is also connected to the ground. An integration capacitor Co and a switch S6 are connected to each other in parallel between the inverted-input terminal and the output terminal of the operational amplifier A2. The output terminal of the operational amplifier A2 is connected to the output pin 28. The switch S6, the integration capacitor Co and the amplifier A2 constitute an output circuit 27.

Let us consider the state of the write node 24 of the second embodiment with the configuration described above. In a write operation, no voltage appears at the write node 24. This is because, during a write operation, the write node 24 is connected to the inverted-input terminal of the operational amplifier A1, that is, a virtual ground point. As a result, no unnecessary electric charge is accumulated in the parasitic capacitor of a common row line. Electric charge is not injected to memory-cell capacitors by variations in voltage occurring on the associated row lines RL1 to RLv. Instead, electric charge is injected by varying the electric potential of the terminal on other side of each memory-cell capacitor using the output of the operational amplifier A1.

By the way, as described earlier, the select switches S11 to Svu of the analog-value memory circuit 21 are each implemented by a semiconductor switch device such as a bipolar transistor, a J (junction-type) FET or a MOSFET. Thus, a PN junction always exists between the terminals of each of the select switches S11 to Svu, causing a leakage current to flow. In the case of a 0.5V signal level and memory-cell capacitors C11 to Cvu each having a capacity of 1 pF, the amount of signal electric charge is not greater than 0.5 pC. In this case, with the delay time set at 100 microseconds and a leakage current of 100 pA flowing between terminals of each of the memory-cell capacitors C11 to Cvu, the resulting leakage-current electric charge is 10 fC which is equal to 1/50 of the signal electric charge. Since a number of switches, that is, a number of PN junctions exist on each common row line, the magnitude of the leakage current increases.

In the case of the present embodiment, however, even if a large leakage current exists and unnecessary electric charge is accumulated on each common row line, the unnecessary electric charge is reset immediately prior to a read operation, eliminating the effect of the leakage current. That is to say, the amount of noise caused by the generation of electric charge due to leakage current can be reduced. The noise-reduction effect can be said also to hold true of the first embodiment described earlier.

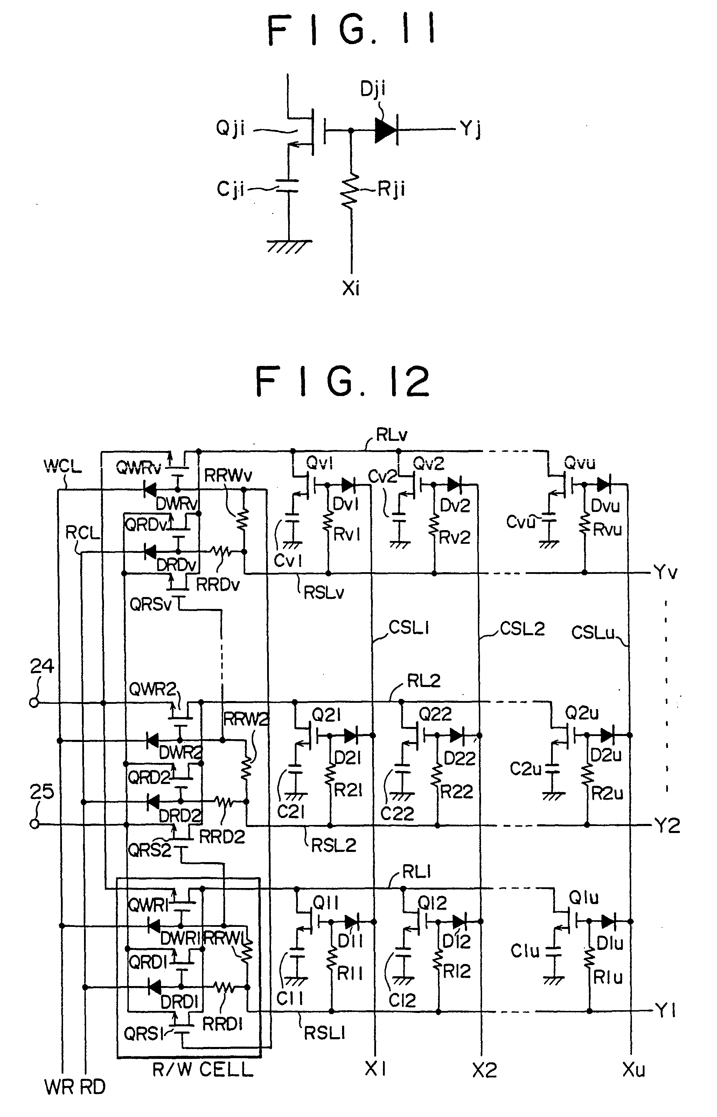

Fig. 11 is a diagram showing the circuit configuration of a memory cell Cij on the ith column and the jth row of a memory-cell matrix with the select switches S11 to Svu each implemented by a MOSFET. As shown in the figure, the gate electrode of the select-switch MOSFET Qij is connected to the anode of a diode Dij and one end of a resistor Rij. A column-select signal Xi and a row-select signal Yj are applied to the other end of the resistor Rij and the cathode of the diode Dij respectively. A read or write operation can be carried out on the memory cell Cij only when both the column-select signal Xi and the row-select signal Yj are both set at a high potential.

A circuit configuration of a third embodiment implementing an analog delay circuit wherein each switch thereof is implemented by an n-channel MOSFET is explained as follows.

Fig. 12 is a circuit diagram showing a third embodiment implementing an analog delay circuit provided by the present invention. As shown in the figure, n-channel MOSFETs QWR1 to QWRv are used as the write switches SWR1 to SWRv respectively. On the other hand, n-channel MOSFETs QRD1 to QRDv are used as the read switches SRD1 to SRDv respectively. Finally, n-channel MOSFETs QRS1 to QRSv are used as the reset switches SRS1 to SRSv respectively.

The sources of the n-channel MOSFETs QWR1 to QWRv which are used as the write switches SWR1 to SWRv respectively are all connected to a write node 24. The drains of the n-channel MOSFETs QWR1 to QWRv are connected to row lines RL1 to RLv respectively. The gates of the n-channel MOSFETs QWR1 to QWRv are connected to the anodes of diodes DWR1 to DWRv respectively. The gates of the n-channel MOSFETs QWR1 to QWRv are also connected to ends of one side of resistors RRW1 to RRWv respectively. The cathodes of the diodes DWR1 to DWRv are all connected to a write control line WCL. The other ends of the resistors RRW1 to RRWv are connected to row-select lines RSL1 to RSLv respectively.

The sources of the n-channel MOSFETs QRD1 to QRDv which are used as the read switches SRD1 to SRDv respectively are all connected to a read node 25. The drains of the n-channel MOSFETs QRD1 to QRDv are connected to the row lines RL1 to RLv respectively. The gates of the n-channel MOSFETs QRD1 to QRDv are connected to the anodes of diodes DRD1 to DRDv respectively. The gates of the n-channel MOSFETs QRD1 to QRDv are also connected to ends on one side of resistors RRD1 to RRDv respectively. The cathodes of the diodes DRD1 to DRDv are all connected to a read control line RCL. The other ends of the resistors RRD1 to RRDv are connected to the row-select lines RSL1 to RSLv respectively.

The sources of the n-channel MOSFETs QRS1 to QRSv which are used as the select switches SRS1 to SRSv respectively are all connected to the read node 25. The drains of the n-channel MOSFETs QRS1 to QRSv are connected to the row lines RL1 to RLv respectively. The gates of the n-channel MOSFETs QRS1 to QRSv are connected to the gates of the n-channel MOSFETs QWRv to QWR(v-1) respectively. As described above, the n-channel MOSFETs QWRv to QWR(v-1) are used as write switches SWRv to SWR(v-1) respectively.

To put it in detail, the gate of the n-channel MOSFET QRS1 of the 1st row is connected to the gate of the n-channel MOSFET QWRv of the vth row and the gate of the n-channel MOSFET QRS2 of the 2nd row is connected to the gate of the n-channel MOSFET QWR1 of the 1st row. Finally, the gate of the n-channel MOSFET QRSv of the vth row is connected to the gate of the n-channel MOSFET QWR(v-1) of the (v-1)th row. With such an arrangement, the reset switches SRS1 to SRSv are controlled by the gate voltages of the n-channel MOSFETs QWRv to QWR(v-1) respectively which are used as write switches SWRv to SWR(v-1) respectively.

Connected to the row line RL1 of the first row are the drains of the n-channel MOSFETs Q11 to Qlu which are used as the select switches S11 to S1u. The terminals on one side of the memory-cell capacitors C11 to C1u are connected to the sources of the n-channel MOSFETs Q11 to Q1u respectively. The other terminals of the memory-cell capacitors C11 to C1u are connected to the ground. The anodes of diodes D11 to D1u are connected to the gates of the n-channel MOSFETs Q11 to Q1u respectively. Also connected to the gates of the n-channel MOSFETs Q11 to Q1u are ends on one side of resistors R11 to R1u. The cathodes of diodes D11 to D1u are connected to column-select lines CSL1 to CSLu respectively. The other ends of the resistors R11 to R1u are connected to a row-select line RSL1.

Much like the first row, connected to the row line RL2 of the second row are the drains of the n-channel MOSFETs Q21 to Q2u which are used as the select switches S21 to S2u respectively. The terminals on one side of the memory-cell capacitors C21 to C2u are connected to the sources of the n-channel MOSFETs Q21 to Q2u respectively. The other terminals of the memory-cell capacitors C21 to C2u are connected to the ground. The anodes of diodes D21 to D2u are connected to the gates of the n-channel MOSFETs Q21 to Q2u respectively. Also connected to the gates of the n-channel MOSFETs Q21 to Q2u are ends on one side of resistors R21 to R2u. The cathodes of diodes D21 to D2u are connected to column-select lines CSL1 to CSLu. The other ends of the resistors R21 to R2u are connected to a row-select line RSL2.

Much like the first and second rows, connected to the row line RLv of the vth row are the drains of the n-channel MOSFETs Qv1 to Qvu which are used as the select switches Sv1 to Svu respectively. The terminals on one side of the memory-cell capacitors Cv1 to Cvu are connected to the sources of the n-channel MOSFETs Qv1 to Qvu respectively. The other terminals of the memory-cell capacitors Cv1 to Cvu are connected to the ground. The anodes of diodes Dv1 to Dvu are connected to the gates of the n-channel MOSFETs Qv1 to Qvu respectively. Also connected to the gates of the n-channel MOSFETs Qv1 to Qvu are ends on one side of resistors Rv1 to Rvu. The cathodes of diodes Dv1 to Dvu are connected to column-select lines CSL1 to CSLu. The other ends of the resistors Rv1 to Rvu are connected to a row-select line RSLv.

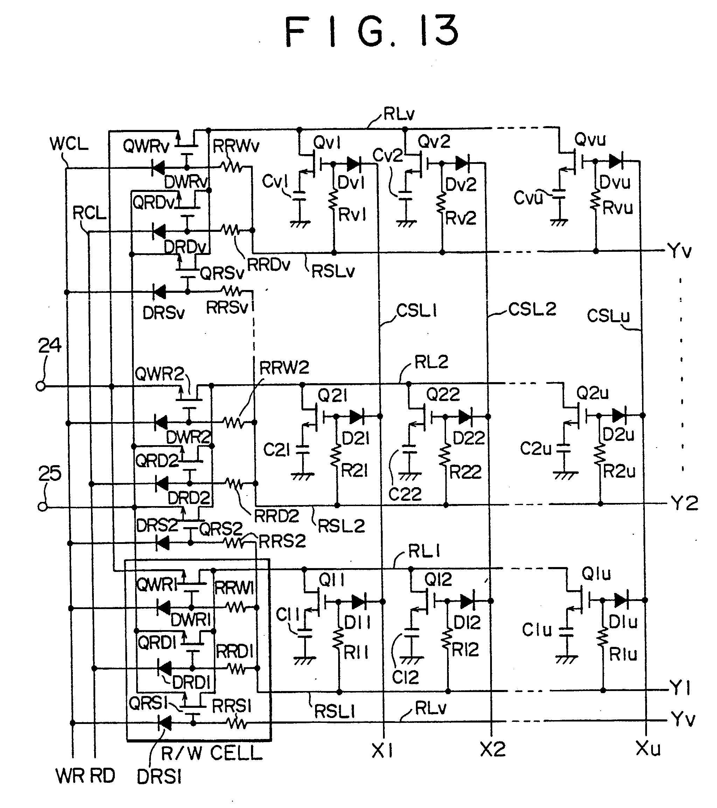

Fig. 13 is a circuit diagram of a fourth embodiment implementing the analog memory circuit provided by the present invention. Each component identical with that shown in Fig. 12 is denoted by the same reference numeral as that of Fig. 12. In the case of the first embodiment, the reset switch SRSj of the jth row is controlled by merely using the gate voltage of the n-channel MOSFET QWR(j-1) on the (j-1)th row which is used as the write switch SWR(j-1) on the (j-1)th row. In the case of the second embodiment, on the other hand, a matrix circuit for reset operations is provided separately.

The purpose of such a separate reset matrix circuit is described as follows. In the third embodiment shown in Fig. 12, the reset switch SRS1 of the first row is controlled by the gate voltage of the n-channel MOSFET QWRv on the last vth row which is used as the write switch SWRv on the vth row. Thinking of construction of such a circuit on an actual chip, a line for the reset control of the reset switch SRS1 alone needs to be extended from a row at the uppermost stage of a memory-cell area to a row at the lowermost stage of the area. As for the other rows, a line for the reset control needs to be extended from a row merely to an adjacent row.

The above requirements give rise to the following two concerns. One of the concerns is that a large parasitic capacitance is developed only on the gate of the n-channel MOSFET QWRv which is used as the write switch SWRv on the vth row and it is quite within the bounds of possibility that the waveform thereof is somewhat different from waveforms of the other rows. The other concern is that the line extended from the 1st row to the vth row forms capacitive coupling with, for example, the read node 25. It is quite within the bounds of possibility that both the concerns cause fixed-pattern noise having correlation with addresses.

Addressing the problems described above, the fourth embodiment shown in Fig. 13 is provided in order to eliminate a return line of the reset signal from the vth row to the first row. That is to say, the reset switch SRSj of the jth row is not controlled by merely using the gate voltage of the n-channel MOSFET QWR(j-1) on the preceding (j-1)th row which is used as the write switch SWR(j-1) on the (j-1)th row as is the case with the first embodiment. Instead, the control signal is output by using a matrix driving technique based on the row-select signal Y(j-1) and the write signal WR.

With the above matrix driving technique, the reset switch SRS1 of the first row is not control by a signal coming from the last vth row. Instead, the gate voltage of the n-channel MOSFET QRS1 is generated by a driving matrix wired at a location close to not only to the last vth row but also close to the first row and based on the write signal WR and the row-select signal Yv provided by the row-select line RLv. In his way, the return line from the vth row to the first row can be eliminated. As a result, good performance can be assured more easily and independently of the layout design on the chip.

Next, differences in actual circuit configuration of the write switches SWR1 to SWRv, the read switches SRD1 to SRDv and the reset switches SRS1 to SRSv between the third and fourth embodiments described above are explained. It should be noted that since there are no any differences in memory-cell portion between the two embodiments, its explanation is omitted.

Much like the analog-value memory circuit shown in Fig. 7, in the analog-value memory circuit shown in Fig. 8, the sources of the n-channel MOSFETs QWR1 to QWRv which are used as the write switches SWR1 to SWRv respectively are all connected to the write node 24. The drains of the n-channel MOSFETs QWR1 to QWRv are connected to row lines RL1 to RLv respectively. The gates of the n-channel MOSFETs QWR1 to QWRv are connected to the anodes of diodes DWR1 to DWRv respectively. The gates of the n-channel MOSFETs QWR1 to QWRv are also connected to ends of one side of resistors RRW1 to RRWv respectively. The cathodes of the diodes DWR1 to DWRv are all connected to a write control line WCL. The other ends of the resistors RRW1 to RRWv are connected to row-select lines RSL1 to RSLv respectively.

The sources of the n-channel MOSFETs QRD1 to QRDv which are used as the write switches SRD1 to SRDv respectively are all connected to a read node 25. The drains of the n-channel MOSFETs QRD1 to QRDv are connected to the row lines RL1 to RLv respectively. The gates of the n-channel MOSFETs QRD1 to QRDv are connected to the anodes of diodes DRD1 to DRDv respectively. The gates of the n-channel MOSFETs QRD1 to QRDv are also connected to ends on one side of resistors RRD1 to RRDv respectively. The cathodes of the diodes DRD1 to DRDv are all connected to a read control line RCL. The other ends of the resistors RRD1 to RRDv are connected to the row-select lines RSL1 to RSLv respectively.

The sources of the n-channel MOSFETs QRS1 to QRSv which are used as the write switches SRS1 to SRSv respectively are all connected to the read node 25. The drains of the n-channel MOSFETs QRS1 to QRSv are connected to the row lines RL1 to RLv respectively. The difference from the analog-value memory circuit shown in Fig. 7 is that, in the analog-value memory circuit shown in Fig. 8, the gates of the n-channel MOSFETs QRS1 to QRSv are connected to the anodes of diodes DRS1 to DRSv respectively. The gates of the n-channel MOSFETs QRS1 to QRSv are also connected to ends on one side of resistors RRS1 to RRSv respectively. The cathodes of the diodes DRS1 to DRSv are all connected to a write control line WCL.

The other ends of the resistors RRS1 to RRSv are connected to the row-select lines RSLv to RSL(v-1) of the preceding row respectively. That is to say, the row-select line RSLv of the vth row is close to the row-select line RSL1 of the first column, and the other end of the resistor RRS1 of the first row, the other end of the resistor RRS2 of the second row, ... and the other end of the resistor RRSv are connected to the row-select line RSLv of the vth row, the row-select line RSL1 of the first row, ... and the row-select line RSL(v-1) of the (v-1)th row respectively.

As described above, according to the present invention, in an analog delay circuit having an analog-value memory circuit comprising memory cells arranged to form a matrix with u columns and v rows with each memory cell comprising a memory-cell capacitor and a switch device, by providing read and write switches for each row, in a state in which a memory cell is selected, the capacitance of a parasitic capacitor connected to input and output nodes is reduced to the capacitance of a parasitic capacitor of only one row which is very small in comparison with the capacitance of a parasitic capacitor of the conventional technology. As a result, the effect of the parasitic capacitor is reduced, allowing electric charge accumulated in a memory-cell capacitor to be read at a high speed. In addition, the number of disturbances caused by unnecessary electric charge accumulated in the parasitic capacitor can also be decreased as well.

On the top of that, by providing a reset switch for each row, electric charge accumulated in a parasitic capacitor of a row can be reset by the reset switch provided for the preceding row immediately prior to an operation to read out the electric charge. As a result, noise generated by the electric charge accumulated in the parasitic capacitor can be eliminated, allowing an analog delay circuit with a high S/N ratio to be implemented. In addition, since effects of electric charge caused by a leakage current generated in a split row line can also be eliminated as well, the S/N ratio can be prevented from deteriorating, allowing a high yield to be anticipated. On the top of that, since the leakage current is much dependent on the temperature, the chip can be relieved from temperature restrictions.

**Claims**

1. An analog delay circuit comprising:

   an analog-value memory circuit comprising (u x v) memory cells (where notations u and v are natural numbers) arranged to form a matrix comprising u columns and v rows wherein each of said memory cells comprises a switch device with a first terminal of said switch device connected to a row line and a memory-cell capacitor connected between a second terminal of said switch device and the ground;

   a read/write circuit comprising sets of switches each comprising a read switch, a write switch and a reset switch for each of said v rows wherein a third terminal of said write switch is connected to an input node while a fourth terminal of said write switch is connected to one end of said row line of said row, a fifth terminal of said read switch is connected to an output node while a sixth terminal of said read switch is connected to said end of said row line of said row, and a seventh terminal of said reset switch is connected to said output node while a eighth terminal of said reset switch is connected to said end of said row line of said row;

   a first scan circuit for sequentially outputting u column-select signals for driving said switch devices of said memory cells on a one-column-after-another basis;

   a second scan circuit for sequentially outputting v row-select signals for driving said switch devices of said memory cells on a one-row-after-another basis; and

   a control circuit for driving and controlling said read/write circuit by using a read signal, a write signal and said row-select signals wherein said jth write switch and said (j + 1)th reset switch (where $1 \leqslant j \leqslant v$ and (v + 1) is treated as 1) are driven with the same timing.

2. An analog delay circuit according to claim 1, wherein said control circuit controls said jth write switch and said (j + 1)th reset switch (where $1 \leqslant j \leqslant$ and (v + 1) is treated as 1) by using the same driving signal.

3. An analog delay circuit comprising:

   an analog-value memory circuit comprising (u x v) memory cells (where notations u and v are natural numbers) arranged to form a matrix comprising u columns and v rows wherein each of said memory cells comprises a switch device with a first terminal of said switch device connected to a row line and a memory-cell capacitor connected between a second terminal of said switch device and the ground and, with the first and the vth rows placed at the lowermost and uppermost stages respectively, an additional wire is further provided as a row line of said vth line under a row line of said first row in addition to a row line for each of said v rows;

a read/write circuit comprising sets of switches each comprising a read switch, a write switch and a reset switch for each of said v rows wherein a third terminal of said write switch is connected to an input node while a fourth terminal of said write switch is connected to one end of said row line of said row, a fifth terminal of said read switch is connected an output node while a sixth terminal of said read switch is connected to said end of said row line of said row and a seventh terminal of said reset switch is connected to said output node while a eighth terminal of said reset switch is connected to said end of said row line of said row;

a first scan circuit for sequentially outputting u column-select signals for driving said switch devices of said memory cells on a one-column-after-another basis;

a second scan circuit for sequentially outputting v row-select signals for driving said switch devices of said memory cells on a one-row-after-another basis; and

a control circuit for driving and controlling said read/write circuit by using a read signal, a write signal and said row-select signals wherein said jth write switch and said $(j + 1)$th reset switch (where $1 \leqslant j \leqslant v$) are driven by a common driving signal and said reset switch of said first row (and said vth write switch) is (are) driven by one of said row-select signals provided through said additional wire serving as said row line of said vth row.

4. An analog delay circuit comprising:

an analog-value memory circuit comprising (u x v) memory cells (where notations u and v are natural numbers) arranged to form a matrix comprising u columns and v rows wherein each of said memory cells comprises a switch device with a first terminal of said switch device connected to a row line and a memory-cell capacitor connected between a second terminal of said switch device and the ground;

a read/write circuit comprising sets of switches each comprising a read switch, a write switch and a reset switch for each of said v rows wherein a third terminal of said write switch is connected to an input node while a fourth terminal of said write switch is connected to one end of said row line of said row, a fifth terminal of said read switch is connected an output node while a sixth terminal of said read switch is connected to said end of said row line of said row

and a seventh terminal of said reset switch is connected to said output node while a eighth terminal of said reset switch is connected to said end of said row line of said row;

a first scan circuit for sequentially outputting u column-select signals for driving said switch devices of said memory cells on a one-column-after-another basis;

a second scan circuit for sequentially outputting v row-select signals for driving said switch devices of said memory cells on a one-row-after-another basis;

a control circuit for driving and controlling said read/write circuit by using a read signal, a write signal and said row-select signals wherein said jth write switch and said $(j + 1)$th reset switch (where $1 \leqslant j \leqslant v$ and $(v + 1)$ is treated as 1) are driven with the same timing; and

an input circuit comprising a first switch, a second switch, a third switch, an input capacitor and an operational amplifier wherein:

a ninth terminal of said first switch is connected to an input pin while a tenth of said first switch is connected to a eleventh terminal of a said second switch and a twelfth terminal of said input capacitor;

said first switch is turned on and off in synchronization with said read signal;

a thirteenth terminal of said input capacitor is connected to the ground and a fourteenth terminal of said second switch is connected to the inverted-input terminal of said operational amplifier;

said second switch is turned on and off in synchronization with said write signal;

an output terminal of said operational amplifier is connected to terminals on one side of said memory-cell capacitors;

said inverted-input terminal of said operational amplifier is also connected to a write node and an uninverted-input terminal of said operational amplifier is also connected to the ground;

said third switch is connected between said inverted-input terminal and said output terminal of said operational amplifier; and

said third switch is turned on and off in synchronization with said read signal.

5. An analog delay circuit according to claim 1, 2, 3 or 4, wherein said read/write circuit is implemented by MOS transistors and a signal is transferred to or from a row line by controlling the gate electrodes of said MOS transistors.

6. An analog delay circuit according to claim 5, wherein a voltage applied to each of said gate electrodes is controlled by dividing the electric potential of said voltage by using a resistor and a diode.

7. An analog delay circuit according to claim 6, wherein a control voltage of each of said MOS transistors is a bias which is added to said gate electrode of said MOS transistor by setting the electric potential of the cathode of said diode at an arbitrary level.

8. An analog delay circuit according to claim 5, wherein a signal for controlling a transistor of said memory cell is supplied to said gate electrode of said MOS transistor.

9. An analog delay circuit according to claim 5, wherein said reset switch is implemented by a MOS transistor, the source electrode of which is set at the same electric potential as the source electrode of a MOS transistor for implementing said write switch.

# F I G. I

# F I G. 2

# F I G. 3

# F I G. 4

NODE A

Y-DIRECTION SCAN CIRCUIT

Yv′

Y2′

Y1′

13

11

X1′  X2′  X3′ ⋯⋯  XU′

X′-DIRECTION
SCAN CIRCUIT

12

# F I G. 5

FIG.6

# F I G. 7

RD

WR

Sij    SELECT AN i j ADDRESS

SRDj    READ

SWRj    WRITE

SRSj+I    RESET THE NEXT ROW

Si+I, j+I    SELECT AN i+I, j+I ADDRESS

SRDj+I    READ

SWRj+I    WRITE

SRSj+2    RESET THE NEXT ROW

T(k)      T(k+I)      T(k+2)

T(k)RD   T(k)WD   T(k+I)RD   T(k+I)WD   T(k+2)RD

EP 0 801 399 A2

# F I G. 8

# F I G. 9

RD

WR

T(k)RD  TWR

S1→ON
  WRITE Vi TO Ci
S3→ON
  CONNECT THE A1 OUTPUT
  TO THE GROUND
S5→ON
  TRANSFER ELECTRIC
  CHARGE OF C(n) TO Co

S2, S4→ON
  TRANSFER ELECTRIC
  CHARGE OF Ci TO C(n)
S6→ON
  RESET Co

F I G. 10

# F I G. 11

# F I G. 12

# F I G. 13